# EUROPEAN PATENT APPLICATION

(11) **EP 2 868 415 A2**
(43) Date of publication of application: **06.05.2015**
(21) Application number: 14188546.7
(22) Date of filing: 10.10.2014
(51) Int. Cl.: B23F 23/00, F16H 55/08

(54) **Gear construction method and digital apparatus**

(30) Priority: 14.10.2013 CN 201310479015
(71) Applicant: Airbus Operations Limited, Bristol BS34 7PA (GB)
(72) Inventor: Hao, Guangxin, Filton, Bristol BS99 7AR (GB); Hu, Yongyang, Filton, Bristol BS99 7AR (GB)
(74) Representative: Teesdale, Emily Catherine

(57) **Abstract**

The present invention relates to a gear construction method, including the steps of: i) setting gear parameters and an XYZ coordinate system; ii) according to the gear parameters, creating a first curve (1) associated with an involute of a tooth profile of a target tooth in an XZ plane, and creating a second curve (2) associated with the involute of the tooth profile of the target tooth in a YZ plane; iii) combining the first curve (1) with the second curve (2) to form a third curve (3) and projecting the third curve (3) onto an XY plane to obtain the involute (4) of the target tooth; and iv) constructing a tooth profile of the target tooth and form a solid model of the entire gear by using the involute (4). The present invention also relates to a digital apparatus associated with the above gear construction method.

## Description

### FIELD OF THE INVENTION

The present invention relates to a gear construction method and a digital apparatus.

### BACKGROUND OF THE INVENTION

The contents in this section only provide background information relating to the present invention which does not necessarily constitute the prior art.

In a conventional gear modeling method, a point tracing process is generally adopted to form an involute of a tooth profile. That is, a series of points is generated in a modeling software according to the computational result externally, and then these points are fit to a curve to approximate the involute. A tooth profile generated by this modeling method is not accurate enough. When this less accurate gear model is employed in subsequent simulation analysis or actual machining, the result of the analysis and the actual product machined are not desirable. In addition, if gear parameters change, each of the points needs to be regenerated and the curve fitting needs to be re-performed, resulting in a very tedious and time consuming modeling process.

### SUMMARY OF THE INVENTION

One object of the present invention is to provide a method capable of accurately constructing a gear.

Another object of the present invention is to provide a method capable of constructing a gear more efficiently.

Still another object of the present invention is to provide a digital apparatus associated with the above gear construction method.

One or more of the above objects may be achieved by a gear construction method. The method may include steps of: i). setting gear parameters and an XYZ coordinate system; ii) according to the gear parameters, creating a first curve associated with an involute of a tooth profile of a target tooth in an XZ plane, and creating a second curve associated with the involute of the tooth profile of the target tooth in a YZ plane; iii) combining the first curve with the second curve to form a third curve and projecting the third curve on an XY plane to obtain the involute of the target tooth; and iv) constructing the tooth profile of the target tooth by using the involute and forming a solid model of the entire gear.

Preferably, in the step ii), the first curve may be obtained by offsetting a reference straight line perpendicular to the XY plane in a direction X, wherein the offset amount in the direction X is: x=rb×sin(t×π)-rb×cos(t×π)×(t×π), and the second curve may be obtained by offsetting the reference straight line in a direction Y, wherein the offset amount in the direction Y is: y=rb×cos(t×π)+rb×sin(t×π)×(t×π), in the above formulas, rb= (m×z/2)×cosα, wherein z is the number of teeth, m is a module, α is a pressure angle, and t is a variable.

Preferably, in the step iii), the first curve is combined with the second curve to form the third curve such that, if any imaginary plane perpendicular to a Z axis is intersected with the first curve at a first point, intersected with the second curve at a second point and intersected with the third curve at a third point, then the third point has an X coordinate corresponding to an X coordinate of the first point and a Y coordinate corresponding to a Y coordinate of the second point.

Preferably, in the step iv), the tooth profile of the target tooth may be created by using the involute and an addendum circle and a root circle of a gear.

Preferably, in the step iv), a sectional profile of the gear may be created by using the tooth profile of the target tooth; and the solid model of the gear may be formed by lofting the sectional profile of the gear along a straight line or a helix.

Preferably, the gear construction method may further include a step v): outputting the formed solid model of the gear for simulation analysis operations or actual machining operations.

Preferably, the gear construction method may be implemented by Pro/Engineer, UG or CATIA.

Preferably, the gear construction method may be implemented in a digital apparatus including at least one of a digital computing apparatus, a digital simulation apparatus and a digital machining apparatus.

Preferably, the present invention further relates to a digital apparatus including: a parameter input part for inputting gear parameters; a first curve forming part for creating a first curve associated with an involute of a tooth profile of a target tooth in an XZ plane according to the gear parameters; a second curve forming part for creating a second curve associated with the involute of the tooth profile of the target tooth in a YZ plane according to the gear parameters; a third curve formation for combining the first curve with the second curve to form a third curve; an involute forming part for projecting the third curve on an XY plane to obtain the involute of the target tooth; and a gear model constructing part for generating a gear model according to the involute of the target tooth.

Preferably, in the first curve forming part, the first curve may be obtained by offsetting a reference straight line perpendicular to the XY plane in an X direction, wherein the offset amount in the X direction is: x=rb×sin(t×π)-rb×cos(t×π)×(t×π), and in the above formula, rb= (m×z/2)×cosα, where z is the number of teeth, m is a module, α is a pressure angle, and t is a variable.

Preferably, in the second curve forming part, the second curve may be obtained by offsetting a reference straight line perpendicular to the XY plane in a Y direction, wherein the offset amount in the Y direction is: y=rb×cos(t×π)+rb×sin(t×π)×(t×π), in the above formula, rb= (m×z/2)×cosα, wherein z is the number of teeth, m is a module, α is a pressure angle, and t is a variable.

Preferably, in the third curve forming part, the first curve may be combined with the second curve to form the third curve such that, if any imaginary plane perpendicular to a Z axis is intersected with the first curve at a first point, intersected with the second curve at a second point and intersected with the third curve at a third point, then the third point has an X coordinate corresponding to an X coordinate of the first point and a Y coordinate corresponding to a Y coordinate of the second point.

Preferably, the gear model constructing part may further include a target tooth profile forming part for creating the tooth profile of the target tooth by using the involute and an addendum circle and a root circle of a gear.

Preferably, the gear model constructing part further includes: a gear profile forming part for forming a sectional profile of the gear by using the tooth profile of the target tooth; and a gear solid model forming part for forming a solid model of the gear by lofting the sectional profile of the gear along a straight line or a helix.

Preferably, the digital apparatus may further include a model output part for outputting a solid model of a gear to a simulation analysis apparatus or an actual machining apparatus.

Preferably, the digital apparatus may include at least one of a digital computing apparatus, a digital simulation apparatus and a digital machining apparatus.

In the above gear construction method and digital apparatus according to the present invention, by creating the first curve associated with the involute of the tooth profile of the target tooth in the XZ plane, creating the second curve associated with the involute of the tooth profile of the target tooth in a YZ plane, as well as combining the first curve with the second curve and projecting the combined curve on an XY plane, the accurate involute of the tooth profile can be formed in a simple manner and thereby the solid model can be formed accurately. In addition, since expressions of the first curve and the second curve are correlated with predetermined gear parameters, the involute of the tooth profile can be changed and formed instantly when gear parameters are changed, thus greatly improving the efficiency of the gear modeling.

Furthermore, since the gear construction method according to the present invention is parameter-driven, the gear construction method according to the present invention can be conveniently embedded in the digital apparatus such as the digital simulation apparatus or the digital machining apparatus, and can be conveniently performed by a special integrated circuit, an individual logic circuit and/or an individual computing circuit or the like in these digital apparatuses. Thus, the simulation result of the digital simulation apparatus and machining accuracy of the digital machining apparatus as well as product accuracy can be improved.

### BRIEF DESCRIPTION OF THE DRAWINGS

Features and advantages of one or more embodiments of the present invention can be understood more readily with reference to the description in conjunction with the drawings in which:
Figure 1 is a schematic view illustrating an involute construction method according to an embodiment of the present invention;
Figure 2 illustrates a relationship between an involute, a base circle, an addendum circle and a root circle of a gear according to the embodiment of the present invention;
Figure 3 illustrates a tooth profile of a target tooth according to the embodiment of the present invention;
Figure 4 illustrates a sectional profile of the entire gear according to the embodiment of the present invention;
Figure 5 illustrates a model of partial surface of the gear according to the embodiment of the present invention;
Figure 6 illustrates a solid model of the gear according to the embodiment of the present invention; and
Figure 7 illustrates a construction of a portion of a digital apparatus according to an embodiment of the present invention.

### DETAILED DESCRIPTION

The following description of the preferred embodiments is only illustrative rather than a limitation to the present invention and application or usage thereof. Throughout the figures, the like reference signs are used to indicate the like elements and thus the description of the like elements will not be repeated.

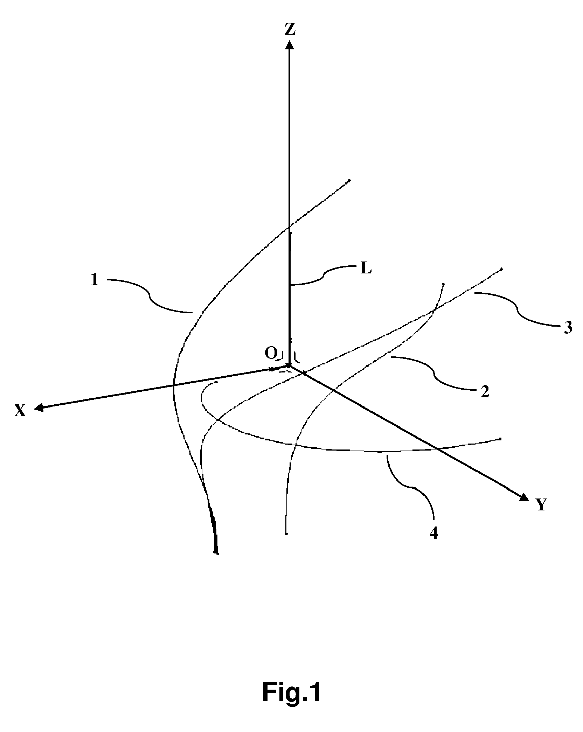

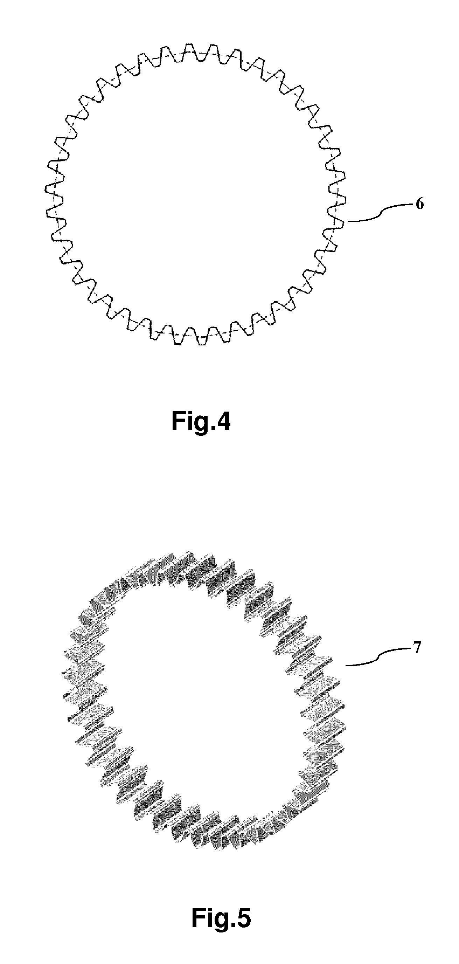

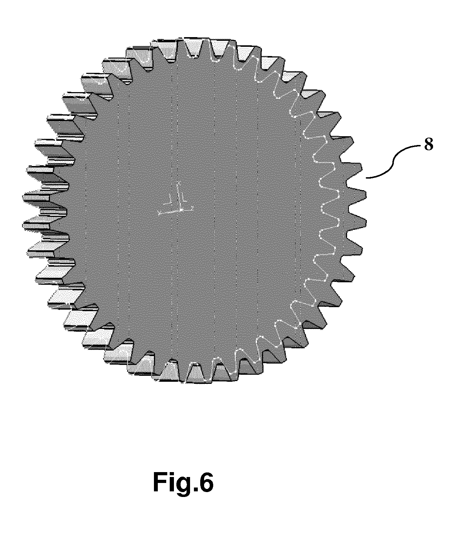

The gear construction method according to the present invention will be described in detail hereinafter with reference to Figs. 1 to 6.

The first step: setting gear parameters.

For example, the following gear parameters may be set: the number of teeth z, a module m, a tooth width B, a pressure angle α, a tooth root coefficient C*, an addendum coefficient ha*. It should be appreciated by those skilled in the art that the gear parameters are not limited to the above parameters; instead they may be chosen appropriately according to various construction methods of a gear model.

The second step: constructing a three-dimensional coordinate system XYZ in which the Z-axis direction is set to be an axial direction of a gear.

The third step: creating a base circle, an addendum circle and a root circle of the gear in an XY plane.

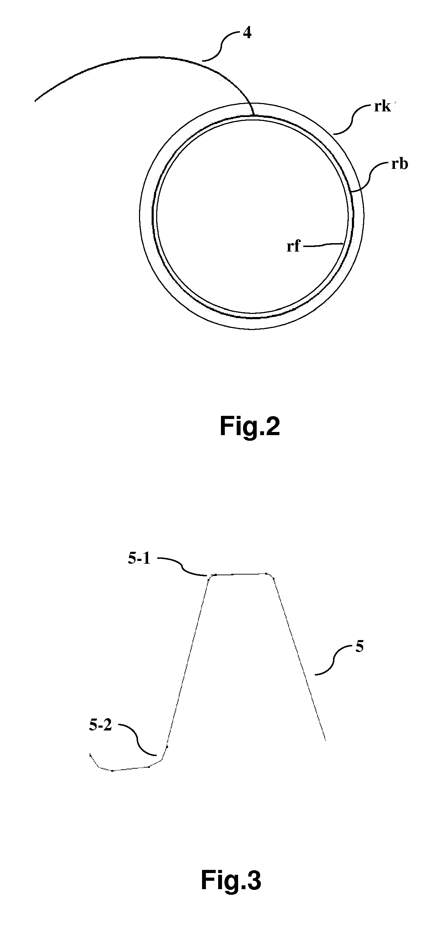

For example, as shown in Fig. 2, the radius of the base circle rb may be rb=r×cosα, the radius of the addendum circle rk may be rk=r+m, and the radius of the root circle may be rf=r-1.25×m. In the above formula, r=mxz/2.

The fourth step: creating a first curve associated with an involute of a tooth profile of a target tooth in an XZ plane, and creating a second curve associated with the involute of the tooth profile of the target tooth in a YZ plane.

More specifically, as shown in Fig. 1, a reference straight line L may be created to be perpendicular to the XY plane, and then may be offset in a direction X to obtain the first curve 1. In particular, an offset amount in the direction X may be: x=rb×sin(t×π)-rb×cos(t×π)×(t×π), in this formula, t is a variable, and for simplicity of the computation, t may have a value ranging [0, 1]. It should be appreciated by those skilled in the art that the above first curve 1 may be obtained by using an OFFSET command in a modeling software such as CATIA to offset the reference straight line L in the direction X, or the above first curve 1 may be created in the XZ plane by directly using the offset amount x=rb×sin(t×π)-rb×cos(t×π)×(t×π). For example, the first curve 1 may be created in the XZ plane by rewriting the above formula as a function of x(z)=rb×sin(z×π)-rb×cos(z×π)×(z×π).

Similarly, as shown in Fig. 1, the second curve 2 may be obtained by offsetting the above reference straight line L in a direction Y. In particular, an offset amount in the direction Y may be: y=rb×cos(t×π)+rb×sin(t×π)×(t×π), in this formula, t is a variable, and for simplicity of the computation, t may have a value ranging [0, 1]. It should be appreciated by those skilled in the art that the above second curve 2 may be obtained by using an OFFSET command in a modeling software such as CATIA to offset the reference straight line L in the direction Y, or the above second curve 2 may be created in the YZ plane by directly using the offset amount y=rb×cos(t×π)+rb×sin(t×π)×(t×π). For example, the second curve 2 may be created in the YZ plane by rewriting the above formula as a function of y(z)=rb×cos(z×π)+rb×sin(z×π)×(z×π).

The fifth step: combining the first curve with the second curve to form a third curve.

More specifically, a combined curve, i.e., the third curve 3 as shown in Fig. 1, may be formed by using a COMBINE command in a modeling software such as CATIA to combine the first curve 1 with the second curve 2. Or in other words, any combining algorithm may be adopted such that, if any imaginary plane perpendicular to a Z axis is intersected with the first curve 1 at a first point, intersected with the second curve 2 at a second point and intersected with the third curve 3 at a third point, then the third point has an X coordinate corresponding to an X coordinate of the first point and a Y coordinate corresponding to a Y coordinate of the second point.

The sixth step: projecting the third curve on the XY plane to obtain the involute of the target tooth.

More specifically, as shown in Fig. 1, a Z-coordinate of the third curve 3 may be set to 0 so as to obtain the involute 4. In addition, Fig. 2 illustrates and a relationship between the involute 4 created in Fig. 1, a base circle rb, an addendum circle rk and a root circle rf of a gear.

The seventh step: creating a tooth profile of the target tooth by using the involute and an addendum circle and a root circle of a gear.

More specifically, the tooth profile 5 of the target tooth may be created by using the involute 4 and the addendum circle rk and the root circle rf of a gear according to any currently known manner, as shown in Fig 3. Corners 5-1, 5-2 of the tooth profile 5 may be chamfered and/or filleted according to requirements so as to form a smoother curve.

The eighth step: creating a sectional profile of the gear by using the tooth profile of the target tooth.

For example, the sectional profile 6 of the entire gear may be formed by annular arraying the tooth profile 5 of the target tooth.

The ninth step: forming a solid model of the entire gear by using the sectional profile of the gear.

For example, a spatial curved surface 7 may be formed by lofting the sectional profile 6 of the gear along a straight line, and subsequently, two end surfaces of the spatial curved surface 7 may be closed to form a solid model 8 of the entire gear (a spur gear). In addition, it should also be appreciated by those skilled in the art, a solid model of a helical gear may be formed by lofting the sectional profile 6 of the gear along a helix.

The tenth step: the solid model of the gear formed may be output for simulation analysis operations or actual machining operations.

It should be appreciated by those skilled in the art, the above gear construction method may be implemented by a conventional modeling software such as Pro/Engineer, UG or CATIA, and it may also be implemented in a digital apparatus such as a digital computing apparatus, a digital simulation apparatus and a digital machining apparatus. In particular, the above gear construction method can be embedded in a digital simulation apparatus or a digital machining apparatus, so as to be performed by a processor, a special integrated circuit, or an individual logic circuit and/or an individual computing circuit in these digital apparatus.

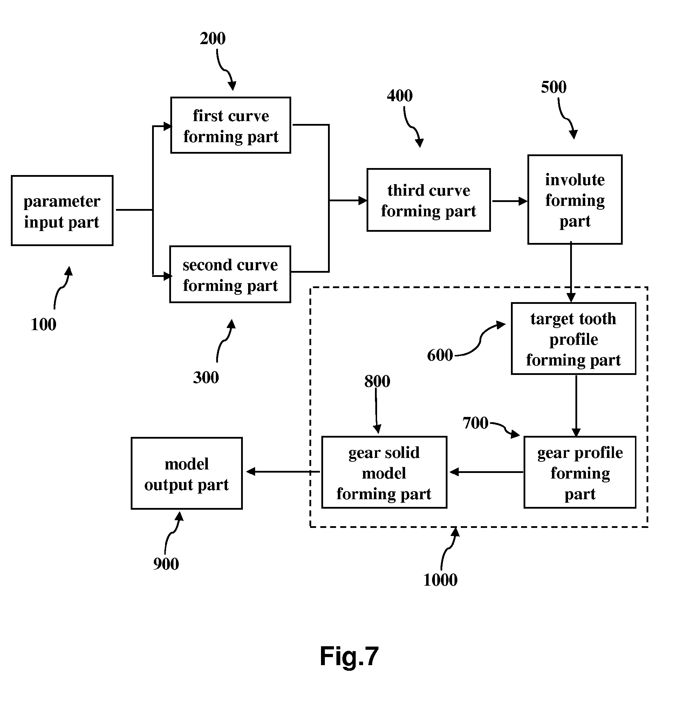

Fig. 7 exemplarily illustrates a portion of a digital apparatus implementing the above gear construction method. More specifically, the digital apparatus may include a parameter input part 100 for inputting gear parameters. The parameter input part 100 may be a keyboard, a mouse or a touch screen, or it may be an interface for communicating with other apparatus, etc.

The digital apparatus may further include a first curve forming part 200 for creating a first curve 1 associated with an involute of a tooth profile of a target tooth in an XZ plane according to gear parameters. The digital apparatus may also include a second curve forming part 300 for creating a second curve 2 associated with the involute of the tooth profile of the target tooth in a YZ plane according to the gear parameters. In particular, the first curve forming part 200 and the second curve forming part 300 may create the first curve 1 and the second curve 2 by performing the corresponding process in the fourth step in the above method.

The digital apparatus may further include a third curve forming part 400 for combining the first curve 1 with the second curve 2 to form a third curve 3. In particular, the third curve forming part 400 may form the third curve 3 by performing the corresponding process in the fifth step in the above method.

The digital apparatus may further include an involute forming part 500 for projecting the third curve 3 on the XY plane to obtain the involute 4 of the target tooth. In particular, the involute forming part 500 may form the involute 4 by performing the corresponding process in the sixth step in the above method.

The digital apparatus may further include a gear model constructing part 1000 for generating a gear model according to the involute 4 of the target tooth. Preferably, the gear model constructing part 1000 may include a target tooth profile forming part 600 for creating a tooth profile of the target tooth by using the involute 4 and an addendum circle rk and a root circle rf of a gear. In particular, the target tooth profile forming part 600 may create the tooth profile 5 of the target tooth by performing the corresponding process in the seventh step in the above method. The gear model constructing part 1000 may further include: a gear profile forming part 700 for forming a sectional profile of the gear by using the tooth profile of the target tooth; and a gear solid model forming part 800 for forming a solid model of the gear by lofting the sectional profile of the gear along a straight line or a helix. In particular, the gear profile forming part 700 may create the sectional profile of the gear by performing the corresponding process in the eighth step in the above method. The gear solid model forming part 800 may create the solid model of the entire gear by performing the corresponding process in the ninth step in the above method.

The digital apparatus may further include a model output part 900 for outputting the formed solid model of the gear to a simulation analysis apparatus or an actual machining apparatus. The model output part 900 may output the solid model of the gear by performing the corresponding process in the tenth step in the above method.

It is to be noted that, the digital apparatus may include at least one of a digital computing apparatus, a digital simulation apparatus and a digital machining apparatus. For example, at least one of the above various modules 100 to 1000 may be constructed to perform certain process by employing a processor and/or a special integrated circuit in the digital apparatus, or at least one of these modules 100 to 1000 may be constructed by an individual logic circuit and/or an individual computing circuit in the digital apparatus.

While various embodiments of the present invention have been described in detail herein, it should be understood that the present invention is not limited to the specific embodiments described in detail and illustrated herein, and those skilled in the art can also make other variants and modifications without departing from the principle and scope of the invention, and these variants and modifications should also be deemed to fall into the protective scope of the invention. Furthermore, all the elements described herein can be replaced by other technically equivalent elements.

## Claims

1. A gear construction method, comprising steps of:
i) setting gear parameters and an XYZ coordinate system;
ii) according to the gear parameters, creating a first curve (1) associated with an involute of a tooth profile of a target tooth in an XZ plane, and creating a second curve (2) associated with the involute of the tooth profile of the target tooth in a YZ plane;
iii) combining the first curve (1) with the second curve (2) to form a third curve (3) and projecting the third curve (3) on an XY plane to obtain the involute (4) of the target tooth; and
iv) constructing the tooth profile of the target tooth by using the involute (4) and forming a solid model of the entire gear.

2. The gear construction method according to claim 1, wherein in the step ii), the first curve (1) is obtained by offsetting a reference straight line (L) perpendicular to the XY plane in a direction X, wherein the offset amount in the direction X is: x=rb×sin(t×π)-rb×cos(t×π)×(t×π), and
the second curve (2) is obtained by offsetting the reference straight line (L) in a direction Y, wherein the offset amount in the direction Y is: y=rb×cos(t×π)+rb×sin(t×π)×(t×π),
in the above formulas, rb= (m×z/2)×cosα, wherein z is the number of teeth, m is a module, α is a pressure angle, and t is a variable.

3. The gear construction method according to claim 1, wherein in the step iii), the first curve (1) is combined with the second curve (2) to form the third curve (3) such that, if any imaginary plane perpendicular to a Z axis is intersected with the first curve (1) at a first point, intersected with the second curve (2) at a second point and intersected with the third curve (3) at a third point, then the third point has an X coordinate corresponding to an X coordinate of the first point and a Y coordinate corresponding to a Y coordinate of the second point.

4. The gear construction method according to claim 1, wherein in the step iv), the tooth profile of the target tooth is created by using the involute (4) and an addendum circle (rk) and a root circle (rf) of a gear.

5. The gear construction method according to claim 4, wherein in the step iv), a sectional profile of the gear is created by using the tooth profile of the target tooth; and the solid model of the gear is formed by lofting the sectional profile of the gear along a straight line or a helix.

6. The gear construction method according to any one of claims 1 to 5, further comprising a step v): outputting the formed solid model of the gear for simulation analysis operations or actual machining operations.

7. The gear construction method according to any one of claims 1 to 5, wherein the gear construction method is implemented by Pro/Engineer, UG or CATIA.

8. The gear construction method according to any one of claims 1 to 5, wherein the gear construction method is implemented in a digital apparatus including at least one of a digital computing apparatus, a digital simulation apparatus and a digital machining apparatus.

9. A digital apparatus, comprising:
a parameter input part (100) for inputting gear parameters;
a first curve forming part (200) for creating a first curve (1) associated with an involute of a tooth profile of a target tooth in an XZ plane according to the gear parameters;
a second curve forming part (300) for creating a second curve (2) associated with the involute of the tooth profile of the target tooth in a YZ plane according to the gear parameters;
a third curve forming part (400) for combining the first curve (1) with the second curve (2) to form a third curve (3);
an involute forming part (500) for projecting the third curve (3) on an XY plane to obtain the involute (4) of the target tooth; and
a gear model constructing part (1000) for generating a gear model according to the involute (4) of the target tooth.

10. The digital apparatus according to claim 9, wherein in the first curve forming part (200), the first curve (1) is obtained by offsetting a reference straight line (L) perpendicular to the XY plane in an X direction, wherein the offset amount in the X direction is: x=rb×sin(t×π)-rb×cos(t×π)×(t×π), and in the above formula, rb= (m×z/2)×cosα, where z is the number of teeth, m is a module, α is a pressure angle, and t is a variable.

11. The digital apparatus according to claim 9, wherein in the second curve forming part (300), the second curve (2) is obtained by offsetting a reference straight line (L) perpendicular to the XY plane in a Y direction, wherein the offset amount in the Y direction is: y=rb×cos(t×π)+rb×sin(t×π)×(t×π), wherein in the above formula, rb= (m×z/2)×cosα, wherein z is the number of teeth, m is a module, α is a pressure angle, and t is a variable.

12. The digital apparatus according to claim 9, wherein in the third curve forming part (400), the first curve (1) is combined with the second curve (2) to form the third curve (3) such that, if any imaginary plane perpendicular to a Z axis is intersected with the first curve (1) at a first point, intersected with the second curve (2) at a second point and intersected with the third curve (3) at a third point, then the third point has an X coordinate corresponding to an X coordinate of the first point and a Y coordinate corresponding to a Y coordinate of the second point.

13. The digital apparatus according to claim 9, wherein the gear model constructing part (1000) further comprises a target tooth profile forming part (600) for creating a tooth profile of the target tooth by using the involute (4) and an addendum circle (rk) and a root circle (rf) of a gear.

14. The digital apparatus according to claim 13, wherein the gear model constructing part (1000) further comprises: a gear profile forming part (700) for forming a sectional profile of the gear by using the tooth profile of the target tooth; and a gear solid model forming part (800) for forming a solid model of the gear by lofting a sectional profile of the gear along a straight line or a helix.

15. The digital apparatus according to any one of claims 9 to 14, further comprising a model output part (900) for outputting the formed solid model of a gear to a simulation analysis apparatus or an actual machining apparatus.

16. The digital apparatus according to any one of claims 9 to 14, wherein the digital apparatus comprises at least one of a digital computing apparatus, a digital simulation apparatus and a digital machining apparatus.
